# EUROPÄISCHE PATENTSCHRIFT

(11) **EP 0 803 075 B1**
(45) Veröffentlichungstag und Bekanntmachung des Hinweises auf die Patenterteilung: **04.12.2002**
(21) Anmeldenummer: 95942017.5
(22) Anmeldetag: 19.12.1995
(51) Int. Cl.: G02B 27/09, G02B 6/42

(54) **OPTISCHE ANORDNUNG ZUR VERWENDUNG BEI EINER LASERDIODENANORDNUNG**
OPTICAL ARRANGEMENT FOR USE IN A LASER DIODE SYSTEM
SYSTEME OPTIQUE S'UTILISANT DANS UN SYSTEME DE DIODE LASER

(30) Priorität: 11.01.1995 DE 19500513; 29.11.1995 DE 19544488
(43) Veröffentlichungstag der Anmeldung: 29.10.1997
(73) Patentinhaber: DILAS DIODENLASER GMBH, 55129 Mainz (DE); Ullmann, Christoph, Dr., 53639 Königswinter (DE); Krause, Volker, 67292 Kirchheimbolanden (DE)
(72) Erfinder: ULLMANN, Christoph, D-53639 Königswinter (DE); KRAUSE, Volker, D-67292 Kirchheimbolanden (DE); KÖSTERS, Arnd, D-55246 Mainz-Kostheim (DE)
(74) Vertreter: Graf, Helmut, Dipl.-Ing.
(86) Internationale Anmeldenummer: DE9501813
(87) Internationale Veröffentlichungsnummer: WO96021877

(56) Entgegenhaltungen:
- EP-A- 0 484 276
- US-A- 3 396 344
- US-A- 5 369 661

## Beschreibung

Die Erfindung bezieht sich auf eine Anordnung zur Kollimation der Strahlung von optoelektrischen Bauelementen in zwei senkrecht zueinander sowie senkrecht zu einer optischen Achse liegenden Koordinatenrichtungen und zur nachfolgenden Fokussierung mit hoher Strahlendichte, und dabei speziell auf eine Anordnung entsprechend Oberbegriff Patentanspruch 1.

Es ist bekannt, daß die Strahlung eines Halbleiterdiodenlasers durch einen stark divergierenden Strahl gekennzeichnet ist, und zwar im Gegensatz zu anderen konvenitonellen Laserstrahlquellen, deren Laserstrahl einen Durchmesser von wenigen Millimetern mit einer geringen Strahldivergenz im Bereich von wenigen mrad aufweist, während die Divergenz bei einem Halbleiterdiodenlaser größer als 1000 mrad ist.

Um die Strahlung eines Halbleiterdiodenlasers nutzen zu können sind kollimierende und fokussierende Mikrooptiken oder optische Anordnungen notwendig. Hierbei ist auch zu berücksichtigen, daß eine Halbleiterlaserdiode in üblicher Weise mehrere Emitter oder Emittergruppen in einer Reihe aufweist, und zwar in einem Abstand von einigen 100 Mikrometern. Bei der Auslegung einer optischen Anordnung oder einer Mikrooptik ist daher zu berücksichtigen, daß die verwendeten Linsen so dicht an dem jeweiligen Halbleiterdiodenlaser bzw. an der entsprechenden Laseranordnung oder an dem Chip vorgesehen werden müssen, daß die Laserstrahlung der einzelnen Emitter oder Emittergruppen sich nicht bereits vor dem Eintritt in die optische Anordnung überlagert, da andernfalls aufgrund von unzulässigen oder unzutreffenden Auftreffwinkeln durch Streustrahlung erhebliche Strahlungsverluste auftreten. Da weiterhin bei Halbleiterlaserdioden der Divergenzwinkel in der Ebene senkrecht zur aktiven Schicht (Fast-Axis) größer ist als in der Ebene der aktiven Schicht (Slow-Axis) ist auch dies bei der Auslegung der optischen Anordnung zu berücksichtigen.

Bekannt ist es, die divergierende Laser-Strahlung von Emittern oder Emittergruppen mit Hilfe zweier in einer optischen Achse hintereinander angeordneter Zylinderlinsen zu kollimieren, wobei durch eine erste Zylinderlinse eine Kollimation in der Fast-Axis, d.h. in der Achse senkrecht zur Ebene der aktiven Schicht und mittels einer zweiten, von der Laserdiodenanordnung weiter entfernten Zylinderlinse eine Kollimation in der Slow-Axis erfolgt.

Bekannt ist hierbei insbesondere auch eine optische Anordnung (US 3 396 344), bei der mehrere Laserdioden oder Emitter bzw. Emittergruppen in wenigstens zwei Reihen übereinander vorgesehen sind, wobei jede Reihe in einer ersten Koordinatenrichtung in der Ebene der aktiven Schicht mehrere Emitter oder Emittergruppen aufweist und die beiden Reihen in einer zweiten Koordinatenrichtung senkrecht zur aktiven Schicht gegeneinander versetzt sind. Zur Kollimation der einzelnen Strahlen ist dann für jede Reihe als Kollimationsoptik eine erste Zylinderlinse vorgesehen, und zwar für eine Kollimation in der zweiten Koordinatenrichtung (Fast-Axis). Für die Kollimation in der ersten Koordinatenrichtung (Slow-Axis) weist eine eine zweite Kollimationsoptik bildende Zylinderlinsenanordnung mehrere Zylinderlinsenelemente auf, die so vorgesehen sind, daß jedes dieser Zylinderlinsenelemente für die Laserstrahlen zweier über einander angeordneter Emitter wirksam ist, die in den beiden benachbarten Reihen einander zugeordnet und unmittelbar benachbart sind.

Da die einander benachbarten Zylinderlinsenelemente in der ersten Kollimationsoptik, insbesondere aber in der zweiten Kollimationsoptik für die angestrebte Kollimation eine bestimmte Linsenhöhe sowie einen bestimmten Krümmungsradius und damit auch bestimmte räumliche Abmessungen erfordern, ist ein relativ großer Abstand der einzelnen Emitter oder Emittergruppen in jeder Reihe notwendig. Dies bedeutet eine relativ geringe Belegungsdichte des die Laserdiodenanordnung bildenden Chips, obwohl von der Chiptechnologie her sowie auch unter Berücksichtigung der Entwicklung von leistungsstarken Kühlern eine weitaus höhere Belegungsdichte und damit eine weitaus höhere Ausgangsleistung möglich wären. Nachteilig ist weiterhin auch, daß sich bei der bekannten optischen Anordnung und insbesondere bei einer Vielzahl von Emittern oder Emittergruppen in jeder Zeile eine Abbildung bzw. eine Fokussierung der Laserstrahlen im Fokus-Punkt ergibt, bei der der Fokusdurchmesser in der ersten Koordinatenrichtung größer ist als in der zweiten Koordinatenrichtung.

Aufgabe der Erfindung ist es, eine optische Anordnung aufzuzeigen, die bei relativ einfachem Aufbau die vorgenannten Nachteile vermeidet und insbesondere wesentlich kleinere Abstände zwischen den Emittern oder Emittergruppen einer Reihe solcher Emitter oder Emittergruppen und damit eine wesentlich höhere Belegungsdichte eines die Laserdiodenanordnung bildenden Chips sowie eine Erhöhung der Ausgangsleistung ermöglicht.

Zur Lösung dieser Aufgabe ist eine optische Anordnung entsprechend dem kennzeichnenden Teil des Patentanspruches 1 ausgebildet.

Die Besonderheit der Erfindung besteht darin, daß die Laserstrahlung benachbarter Emitter oder Emittergruppen einer Reihe so umgelenkt werden, daß die kollimierten Laserstrahlen benachbarter Emitter oder Emittergruppen nach dem Durchtritt durch die zweite Kollimationsoptik parallel zueinander in unterschiedlichen, gegeneinander versetzten Strahlebenen vorliegen, d.h. beispielsweise in in der Achse senkrecht zur Ebene der aktiven Schicht gegeneinander versetzten Stahlebenen. In diesen werden die Laserstrahlen jeweils in der Slow-Achse, d.h. beispielsweise in der ersten Koordinatenrichtung kollimiert, so daß auch die hierfür verwendeten Kollimationselemente, z.B. Zylinderlinsenelemente, der zweiten Kollimationsoptik in diesen Strahlebenen angeordnet sind und sich somit in unterschiedlichen Strahlebenen angeordnete Kollimationselemente überlappen können. Hierdurch können kleine Abstände zwischen den einzelnen Emitter oder Emittergruppen und damit eine hohe Belegungsdichte realisiert werden. Beträgt die Anzahl der verwendeten Strahlebenen *n* und ist *a* der Abstand, den benachbarte Emitter oder Emittergruppen voneinander aufweisen, so ergibt sich an der zweiten Kollimationsoptik ein Abstand der Kollimationselemente in jeder Stahlebene von *n x a*, d.h. selbst bei kleinem Abstand *a* und bei hoher Belegungsdichte ist der aus baulichen Gründen erforderliche Abstand der Kollimationselemente in jeder Strahlebene realisierbar.

Unter "nicht-zentrisch abbildende Kollimationsoptik" oder "zylindrisch wirkende Kollimationsoptik" ist im Sinne der Erfindung generell eine Zylinderoptik oder eine Optik zu verstehen, die gleich oder ähnlich einer Zylinderlinse abbildet.

Die in den beiden Ebenen kollimierten Laserstrahlen können dann durch eine Fokussieroptik in einem gemeinsamen Raumbereich oder Fokus abgebildet werden.

Der besondere Vorteil der Erfindung besteht u.a. darin, daß unter Beibehaltung einer relativ einfachen Bauform die Verwendung einer Laserdiodenanordnung mit hoher Belegungsdichte und damit mit hoher Laserleistung möglich ist, ohne daß es durch Streustrahlung zu Verlusten kommt. Es sind daher auch unter Verwendung der zur Verfügung stehenden Hochleistungskühlertechnologie Halbleiterdiodenlaser für höchste Leistungen realisierbar.

Die Erfindung bietet weiterhin den Vorteil, daß bei einer vorgegebenen Anzahl von Emittern oder Emittergruppen in einer Reihe durch entsprechende Wahl der Anzahl der Strahlebenen die Form des Fokuspunkts in einer angestrebten Weise gestaltet werden kann, beispielsweise ein runder oder nahezu runder Fokuspunkt möglich ist.

Bei einer einfachen Ausführungsform der Erfindung sind die Emitter oder Emittergurppen nur in einer Reihe angeordnet. Bei der Erfindung ist es aber auch möglich, mehrere Reihen solcher Emitter oder Emittergruppen in einer Koordinatenrichtung senkrecht zur Ebene der aktiven Schicht vorzusehen.

Weiterbildungen der Erfindung sind Gegenstand der Unteransprüche.

Die Erfindung wird in Folgenden anhand der Figuren an Ausführungsbeispielen näher erläutert. Es zeigen:
- Fig. 1: in vereinfachter Darstellung und in Seitenansicht eine Laserdiodenanordnung mit mehreren, in einer Koordinatenrichtung senkrecht zur Zeichenebene dieser Figur (X-Achse) hintereinander angeordneten Emittern oder Emittergruppen und mit einer Ausführungsform der erfindungsgemäßen optischen Anordnung zur Fokussierung der Strahlung der einzelnen Emitter in einem gemeinsamen Fokus;
- Fig. 2: die Laserdiodenanordnung sowie die zugehörige optische Anordnung der Figur 1 in Draufsicht, d.h. in einer gegenüber der Figur 1 um 90° gedrehten Ansicht bei einer Ausführungsform, bei der in der X-Achse senkrecht zur Zeichenebene der Figur 1 drei Enmitter bzw. Emittergruppen aufeinanderfolgend vorgesehen sind;
- Fig. 3: eine Darstellung ähnlich Figur 2, jedoch bei einer Ausführungsform, bei der parallel zur aktiven Schicht der Laserdiodenanordnung, d.h. in der X-Achse insgesamt sechs Emitter oder Emittergruppen vorgesehen sind;
- Figuren 4 und 5: in Darstellungen ähnlich Figur 1 weitere, mögliche Ausführungsformen der Erfindung;
- Fig. 6: in einer Darstellung ähnlich Figur 1 eine weitere Ausführungsform, bei der in einer Ebene senkrecht zur aktiven Schicht übereinander mehrere Reihen von Emittern oder Emittergruppen vorgesehen sind, die in jeder Reihe senkrecht zur Zeichenebene der Figur hintereinander angeordnet sind, sowie eine optische Anordnung zur Fokussierung der Strahlung sämtlicher Emitter oder Emittergruppen in einem gemeinsamen Fokus;
- Figuren 7 und 8: in ähnlicher Darstellung wie Figuren 1 und 2 eine weitere mögliche Ausführungsform;
- Figuren 9 - 11: in einer Ansicht weitere Ausführungsformen, die sich durch die erste Kollimationsoptik unterscheiden;
- Figuren 12 - 14: in Teildarstellung weitere mögliche Ausführungsformen der Erfindung;

In den Figuren sind jeweils mit X, Y und Z drei senkrecht zueinander angeordnete Koordinatenrichtungen angegeben, die nachfolgend auch als X-Achse, Y-Achse und Z-Achse bezeichnet sind.

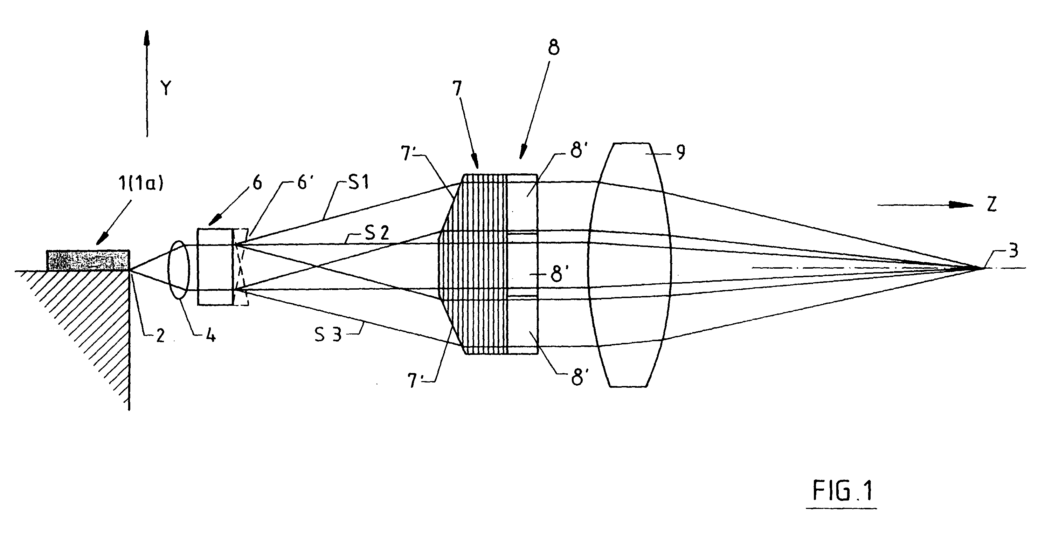

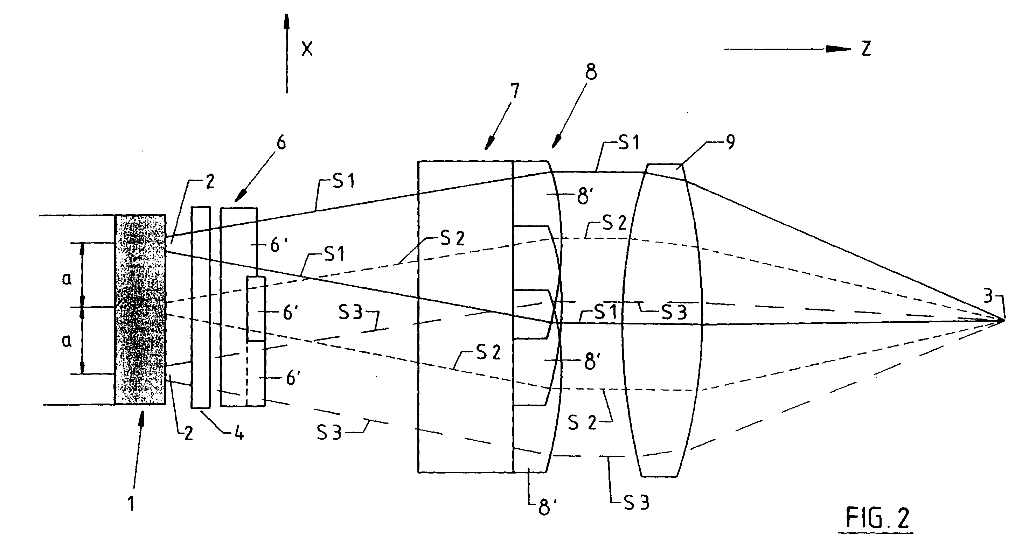

Die Figuren 1 und 2 zeigen eine Laserdiodenanordnung 1 in Form eines Laserdiodenchips, der der einfacheren Darstellung und Erläuterung wegen nur insgesamt drei Emitter oder Emittergruppen 2 besitzt, die in Richtung der aktiven Schicht dieser Emitter in der X-Achse in einer Reihe aufeinanderfolgend und mit einem vorgegebenen Abstand a angeordnet sind.

Die einzelnen Emitter bzw. Emittergruppen 2 liefern, wie oben ausgeführt wurde, eine Strahlung, die in der Ebene senkrecht zur aktiven Schicht (Zeichenebene der Figur 1) wesentlich stärker divergiert als in der Ebene der aktiven Schicht (Zeichenebene der Figur 2). Zum besseren Verständnis sind die Randlinien der Strahlen der drei Emittergruppen 2 in den Figuren 1 und 2 jeweils mit S1, S2 und S3 bezeichnet.

Um die Strahlung der Emittergruppen 2 voll nutzen zu könnnen, ist es notwendig, diese Strahlung in einem gemeinsamen Punkt 3 zu fokussieren, und zwar derart, daß sich in beiden Ebenen, d.h. in der Ebene senkrecht zur aktiven Schicht der Emittergruppen 2 und in der Ebene parallel zu dieser aktiven Schicht, ein möglichst gleich großer Fokusdurchmesser ergibt d.h. ein möglichst runder Fokuspunkt erzielt wird, wie dies beispielsweise für die Einspeisung der Strahlung am Punkt 3 in eine nicht dargestellte Faseroptik notwendig oder zumindest zweckmäßig ist.

Diese Fokussierung erfolgt mittels der in den Figuren 1 und 2 ebenfalls dargestellten optischen Anordnung. Diese besteht aus den nachfolgend angegebenen Elementen, die sich in der Reihenfolge der nachfolgenden Auflistung ausgehend von der Laserdiodenanorndung 1 in Richtung der optischen Achse der optischen Anordnung bzw. in Richtung der Z-Achse aneinanderanschließen, wobei bei der dargestellten Ausführungsform diese durch den Fokuspunkt 3 hindurchführende optische Achse in der Ebene der aktiven Schicht der Emittergruppen liegt und senkrecht zu der X-Achse erfolgt:
- Zylindrisches Linsenelement oder Zylinderlinse 4 mit asphärischer Zylinderoberfläche;
- erster Prismenblock 6 mit mehreren in Richtung senkrecht zur optischen Achse sowie in der aktiven Ebene der Emittergruppen 2, d.h. in der X-Achse hintereinander angeordneten Prismenelementen 6', deren Anzahl und Abstand der Anzahl der Emittergruppen 2 und deren Abstand a entspricht;
- zweiter Prismenblock 7 mit insgesamt drei in einer Koordinatenrichtung senkrecht zur optischen Achse und senkrecht zur aktiven Ebene der Emittergruppen 2, d.h. in der Y-Achse aufeinander folgend vorgesehenen unterschiedlichen Prismenelementen 7';
- Zylinderlinsenanordnung 8, die mehrere Zylinderlinsenelemente 8' aufweist, die mit ihren Zylinderachsen in der Koordinatenrichtung der Y-Achse angeordnet sind, und zwar bezogen auf diese Y-Achse in drei Ebenen übereinander und in der X-Achse von Ebene, zu Ebene jeweils versetzt, und zwar um einen Betrag, der gleich dem Abstand *a* der Emittergruppen 2 ist;
- Sammellinse 9, die rotationssymmetrisch zur optischen Achse bzw. Z-Achse ausgebildet ist und bei der dargestellten Ausführungsform eine bikonvexe Linse ist.

Anstelle der Sammellinse 9 kann auch eine andere optische Fokussiereinrichtung, beispielsweise eine mehrlinsige Fokussiereinrichtung vorgesehen sein.

Die Wirkungsweise dieser optischen Anordnung läßt sich, wie folgt, beschreiben:
Der Laserstrahl S1-S3 jeder Emittergruppe 2, der sowohl in der jeweiligen Ebene parallel zur aktiven Schicht, als auch in der jeweiligen Ebene senkrecht zur aktiven Schicht einen großen Devergenzwinkel aufweist, wird zunächst in der Ebene (Y-Z-Ebene) senkrecht zur aktiven Schicht durch die Zylinderlinsenanordnung 4, die mit ihrer Zylinderachse in der X-Achse angeordnet ist, bis auf wenige mrad Divergenz kollimiert. Das Zylinderlinsenelement 4 verfügt hierfür, wie oben ausgeführt, über ein aspherische Zylinderoberfläche. Die Abmessung des jeweiligen Laserstrahles beträgt nach der Kollumation beispielsweise 0,5 bis 1,5 mm. Der so in der jeweiligen Y-Z-Ebene senkrecht zur aktiven Schicht kollimierte Laserstrahl jeder Emittergruppe tritt in das für diese Emittergruppe vorgesehenen Prismenelement 6' des ersten Prismenblockes 6 ein.

Die einzelnen Prismenelemente 6' sind so ausgebildet, daß sie in der Ebene senkrecht zur aktiven Schicht jeweils in unterschiedlicher Form eine Ablenkung des Laserstrahles bewirken, und zwar wird der Laserstrahl S 1 der einen, außenliegenden Emittergruppe 2 durch das zugehörige Prismenelement 6' um einen spitzen Winkel, beispielsweise um einen Winkel von 10° bei der für die Figur 1 gewählten Darstellung nach oben abgelenkt, der Laserstrahl S2 der mittleren Emittergruppe 2 erfährt durch das zugehörige Prismenelement 6' keine Ablenkung und der Laserstrahl S3 der anderen außenliegenden Emittergruppe 2 wird bei der für die Figur 1 gewählten Darstellung um einen Winkel, d.h. bei dieser Ausführungsform um den gleichen Winkel wie der Stahl S1, beispielsweise um den Winkel von 10°, allerdings nach unten abgelenkt. Die Breite der Prismenelemente 6' in Richtung der X-Achse entspricht dabei genau dem Abstand *a* der Emittergruppen 2.

Die abgelenkten, in der Y-Z-Ebene kollimierten und in der X-Z-Ebene noch divergierenden Strahlen S1 - S3 treffen auf den größeren, zweiten Prismenblock 7 bzw. jeweils auf ein dortiges für jeden Stahl S1 - S3 und damit für jede Emittergruppe 2 gesondert vorgesehenes Prismenelement 7'. Die dem Prismenblock 6 zugewandten, senkrecht zur Y-Z-Ebene liegenden Flächen dieser Prismenelemente 7'sind so gegenüber der optischen Achse bzw. Z-Achse geneigt bzw. schließen einen solchen Winkel mit dieser Achse ein, daß sich im Prismenblock 7 in drei Stahlungsebenen übereinander parallele Laserstrahlen S1 - S3 ergeben.

An der dem Prismenblock 6 abgewandten Seite des Prismenblock 7 ist die Zylinderlinsenanordnung 8 vorgesehen, und zwar beispielsweise dadurch, daß auf dieser in einer Ebene senkrecht zur optischen Achse (Z-Achse) liegenden Planseite des Prismenblockes 7 die einzelnen Halbzylinderlinsenelemente 8' in der oben beschriebenen Anordnung in drei Reihen übereinander aufgekittet sind. Jedes Zylinderlinsenelement 8' ist wiederum einem Strahl S1 - S3 zugeordnet und bewirkt eine Kollimation dieses Stahles S1, S2 bzw. S3 in der X-Z-Ebene, so daß dann nach der Zylinderlinsenanordnung 8 jeder Stahl sowohl in der X-Achse als auch in der Y-Achse kollimiert ist und die so kollimierten Strahlen S1 - S3 mit der herkömmlichen Sammellinse 9 auf den gemeinsamen Fokus-Punkt 3 abgebildet werden können. Die plankonvexen Zylinderelemente 8' können sphärisch oder asphärisch sein.

Es versteht sich, daß die beschriebene optische Anordnung auch für Emitteranordnungen verwendet werden kann, die mehr als drei Emittergruppen aufweisen. In diesem Fall erhöht sich beispielsweise lediglich die Anzahl der Prismenelemente 6' und damit die Anzahl der in die drei Stahlebenen abgelenkten Strahlen Sl - Sn, wobei dann im größerem Prismenblock 7 in jeder Stahlebene zwei oder mehr als zwei Strahlen nebeneinander vorgesehen sind und die Zylinderlinsenanorndung 8 in jeder Ebene wenigstens zwei Zylinderlinsenelemente 8' aufweist, die in jeder Ebene einen Abstand voneinander besitzen, der gleich dem Abstand *a* der Emittergruppen an der Laserdiodenanordnung 1 multipliziert mit der Anzahl der Strahlebenen im Prismenblock 7 ist. Es versteht sich, daß weiterhin eine entsprechende Ausbildung der Prismenblöcke 6 und 7 auch mehr als drei Strahlebenen in der Y-Achse übereinander vorgesehen sein können, beispielsweise fünf Strahlebenen übereinander.

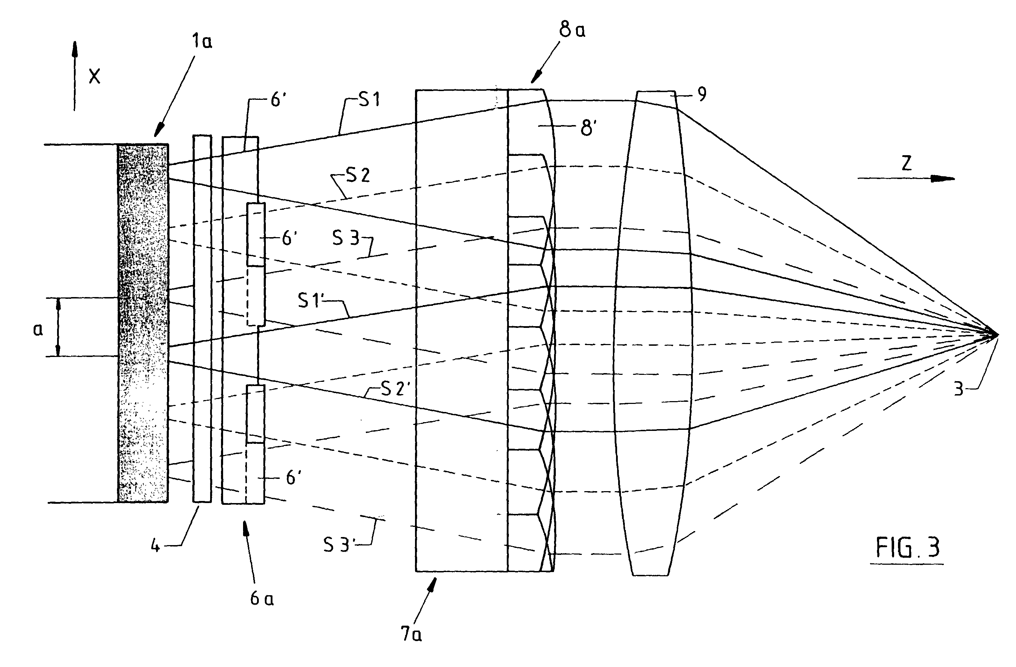

Figur 3 zeigt in ähnlicher Darstellung wie Figur 2 eine Ausführung, bei der die Laserdiodenanordnung 1a insgesamt sechs Emittergruppen 2 aufweist, deren Laserstrahlen durch den Prismenblock 6a so abgelenkt werden, daß sich innerhalb des Prismenblockes 7a wiederum drei Strahlebenen ergeben, die in der Y-Achse übereinander angeordnet sind, und zwar in jeder Strahlebene in Richtung der X-Achse nebeneinander zwei unabhängige Strahlen, nämlich in der oberen Ebene die Strahlen S1 und S1', in der mittleren Ebene die Strahlen S2 und S2' und in der unteren Ebene die Strahlen S3 und S3'. Die Anzahl der Prismenelemente 6' ist gleich der Anzahl der Emittergruppen. Die Anzahl der Prismenelemente 7' ist gleich der Anzahl der Strahlebenen. Darüber hinaus sind die Prismenelemente 6' so ausgebildet, daß der Strahl einer Emittergruppe 2 zusammen mit demjenigen Strahl in eine Strahlebene abgelenkt wird, der der in der Reihe der Emittergruppe folgenden *n*-ten Emittergruppe entspricht, wobei *n* die Anzahl der in der Y-Achse übereinander angeordneten Strahlebenen ist. Anstelle der Zylinderlinsenanordnung 8 ist in der Figur 3 die Zylinderlinsenanordnung 8a verwendet, die in jeder Stahlebene zwei Zylinderlinsenelemente 8' aufweist, die von Strahlebene zu Strahlebene wiederum um den Abstand *a* in der X-Achse versetzt sind und in dieser Achse in jeder Stahlebene einen Abstand von *n x a* aufweisen.

Mit der erfindungsgemäßen Ausbildung wird bereits bei Aufteilung der Laserstrahlen der Emittergruppen auf zwei Strahlebenen eine wesentliche Verbesserung, insbesondere auch hinsichtlich der Fokussierung gegenüber bekannten optischen Anordnungen erreicht, die die Aufteilung der Laserstrahlen in verschiedenen Strahlebenen nicht vorsehen. Hierzu wird auf die nachfolgende Tabelle verwiesen. In dieser ist ein Vergleich des Abbildungsverhaltens einer Laserdiodenanordnung mit einer Länge von 10 mm in der X-Achse und mit einem Emitterabstand von 800 Mikrometer sowie einer Emitterbreite von 400 Mikrometer für drei unterschiedliche optische Anordnungen wiedergegeben, und zwar für eine Anordnung mit nur einer Strahlebene, d.h. ohne Ablenkung (1-Ebene), für die im Zusammenhang mit den Figuren 1 - 3 beschriebene Anordnung mit drei Strahlebenen (3-Ebene) sowie für eine optische Anordnung, bei der die Ablenkung in fünf in der Y-Achse übereinander angeordneten Strahlebenen erfolgt (5-Ebene).

Auf dem Laserdioden-Chip oder -Barren sind dreizehn Emittergruppen angeordnet. Um den Einfluß der ersten Kollimationsoptik, d.h. der Zylinderlinsenanordnung 4 abzuschätzen, wird eine voller Divergenzwinkel von 20mrad in der Y-Achse nach Transmission der Laserstrahlen durch diese Linsenanordnung angenommen. Der Divergenzwinkel einer einzelnen Emittergruppe 2 bestimmt den Abstand der Zylinderlinsenanordnung 8 bzw. der Zylinderlinsenelemente 8' von der Laserdiodenanordnung bzw. von dem Laserdiodenchip, da der ideale Abstand durch die Entfernung des Ortes der Überlagerung der Strahlung zweier Emittergruppen vom Laserdiodenchip vorgegeben ist. Der Divergenzwinkel in der X-Z-Ebene wird für die Berechnung mit 10° angenommen. Für die Fokussierung mit der Sammellinse 9 wird eine numerische Apertur von 0,2 zugrundegelegt, was der üblichen numerischen Apertur für eine Faserkopplung in eine Quarzfaser entspricht. Der Öffnungswinkel beträgt dann 23°.

**Tabelle**

| | 1-Ebene | 3-Ebene | 5-Ebene |
|---|---|---|---|
| Brennweite Zylinderlinse 8 (mm) | 2,28 | 11,43 | 20,57 |
| Brennweite Sammellinse 9 (mm) | 25,6 | 29,5 | 34,4 |
| Vergrößerung | 11,2 | 2,6 | 1,67 |
| Fokusdurchmesser in X-Achse (mm) | 4,48 | 1,04 | 0,67 |
| Fokusdurchmesser in Y-Achse (mm) | 0,51 | 0,59 | 0,69 |

Die vorliegende Tabelle bestätigt, daß bei einer optischen Anordnung mit nur einer Ebene aufgrund der sehr geringen Brennweite der "Slow-Achsen-Optic", d.h. der die Kollimation in der X-Achse bewirkenden Optik, die größte Ausdehnung des Fokus in dieser Achse liegt. Wird hingegen die Strahlung der Emittergruppen auf mehrere Strahl-Ebenen aufgeteilt, wie dies die Erfindung vorsieht, so kann ein erheblich geringer Fokusdurchmesser erreicht werden, insbesondere auch in der X-Achse, wobei es bei einer entsprechenden Anzahl von Strahlebenen auch möglich ist, eine nahezu runden Fokuspunkt 3, d.h. gleiche Fokus-Durchmesser in der X- und Y-Achse zu erzielen.

Wesentlich ist bei der Erfindung auch, daß die Aufspaltung der Strahlen in die verschiedenen Strahlebenen auf jeden Fall bis zum Eintritt in die Zylinderlinsenanordnung 8 bzw. 8a abgeschlossen ist, so daß dann für diese Anordnung je nach Ausbildung (zwei oder mehr als zwei Ebenen) 10-20 mm als Brennweite zur Verfügung stehen. Bei einer Linsenhöhe von 1 mm, einem Abstand von 5 mm zwischen der Austrittsseite des jeweiligen Prismenelementes 6' und der Eintrittsfläche des jeweiligen Prismenelementes 7' und einem Brechungsindex von 1,5 dieser Elemente ergibt sich dann bei einer Verwendung von drei Strahlebenen ein Neigungswinkel der positiv und negativ abgeschrägten Flächen der Prismenelemente 6' von etwa 20°. Vermindert kann dieser Winkel werden z.B. durch einen höheren Brechungsindex der Prismenelemente 6' und 7', durch eine geringere Linsenhöhe der Linsenelemente 8' sowie durch einen größeren Abstand zwischen den Prismenblöcken 6 und 7.

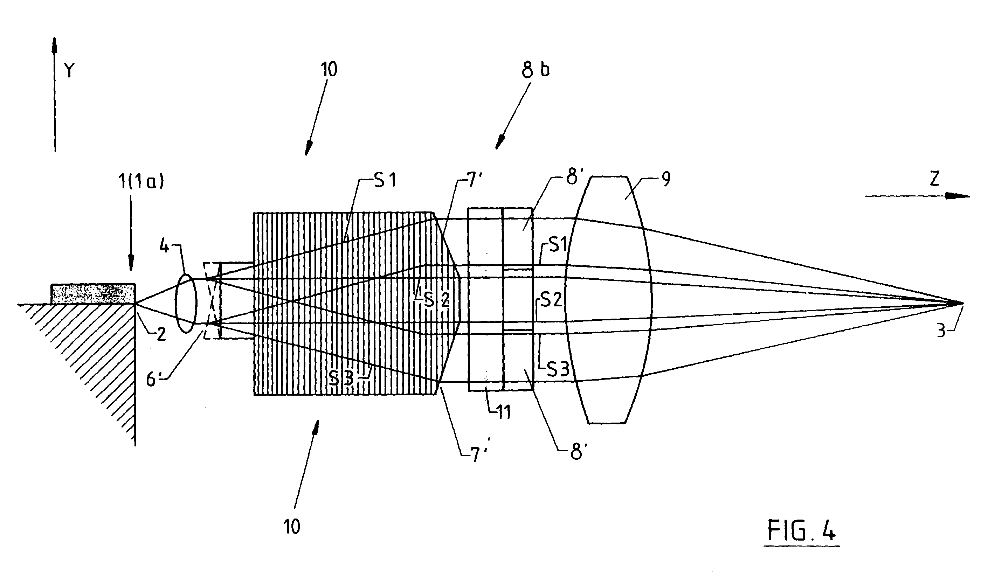

Figur 4 zeigt eine weitere, mögliche Ausführungsform, die sich von der Ausführungsform der Figur 1 dadurch unterscheidet, daß anstelle von separaten Prismenblöcken 6 und 7 ein kombinierter Prismenblock 10 vorgesehen ist, der an seiner dem Zylinderlinsenelement 4 zugewandten Seite die Prismenelemente 6' und an seiner einer Zylinderlinsenanordnung 8b zugewandten Ausgangsseite die Prismenelemente 7' bzw. die entsprechenden Prismenflächen bildet. Die Zylinderlinsenanorndung 8b entspricht der Zylinderlinsenanordnung 8 oder 8a, ist aber getrennt von dem Prismenblock 10 vorgesehen und besteht aus diesem Grunde aus einer optisch neutralen Scheibe 11, auf die die Zylinderlinsenelemente 8' aufgekittet sind.

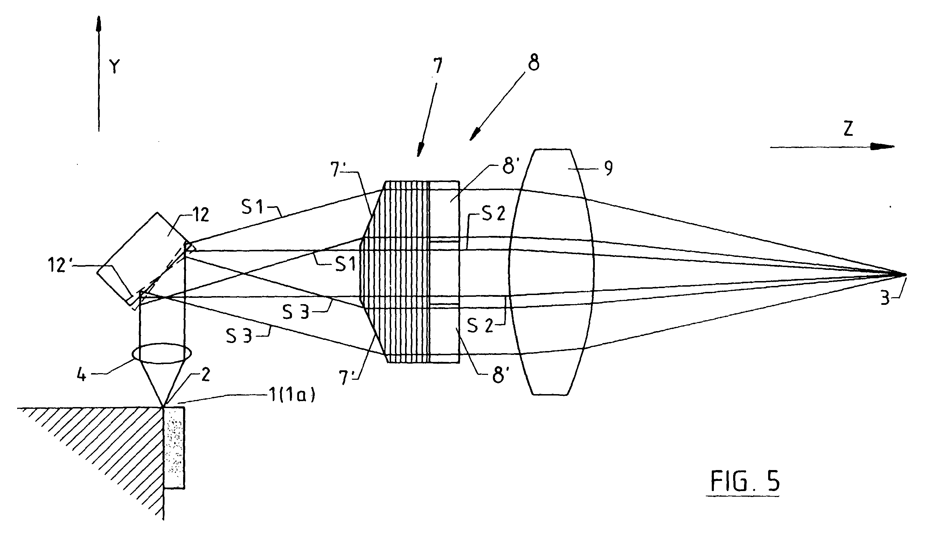

Figur 5 zeigt eine Ausführungsform, die sich von der Ausführung der Figur 1 dadurch unterscheidet, daß anstelle des Prismenblockes 6 bzw. eines transparenten Elementes ein reflektierendes Element 12 vorgesehen, welches für jede Emittergruppe 2 unterschiedliche Reflektionsflächen 12' bildet, um wiederum die beschriebene Ablenkung der Strahlen S1 - S3 bzw. S1 - S3' in die unterschiedlichen Strahlebenen zu erreichen.

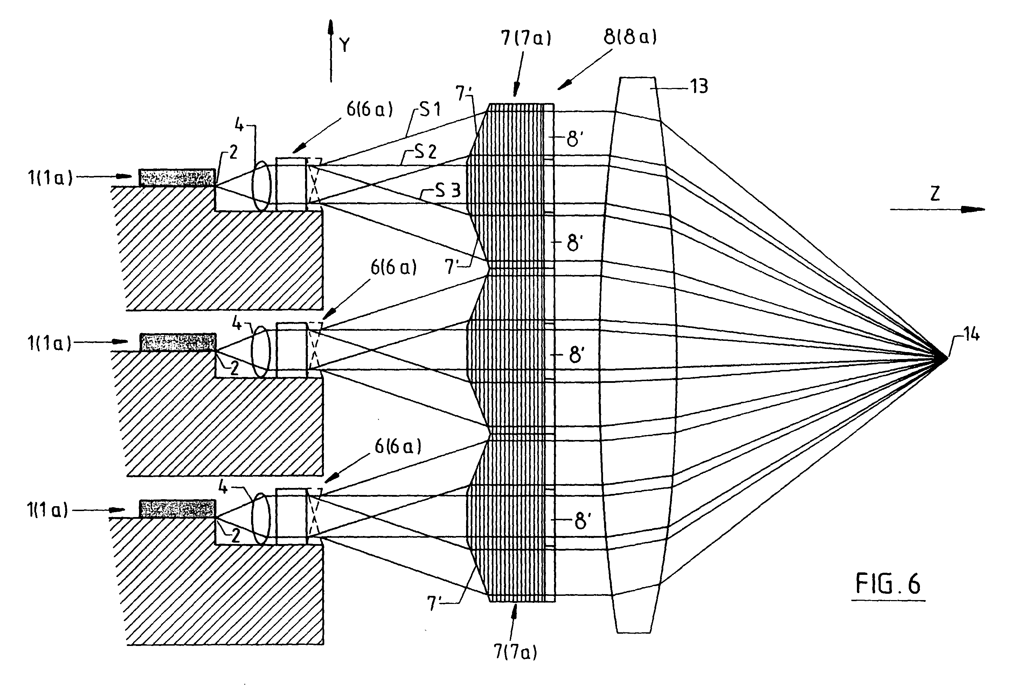

Figur 6 zeigt schließlich eine Ausführungsform, bei der mehrere Laserdiodenanordnungen 1 oder 1a in der Y-Achse übereinander angeordnet sind, wobei jede Laserdiodenanordnung 1 oder 1a in der X-Achse wiederum eine Vielzahl von Emittern oder Emittergruppen 2 besitzt.

Jeder Laserdiodenanordnung 1 oder 1a sind die Prismenblöcke 6 und 7 mit der Zylinderlinsenanorndung 8 zugeordnet, um die einzelnen Strahlen der Emittergruppen in unterschiedliche Strahlebenen, d.h. bei der für die Figur 6 gewählten Darstellung wiederum für jede Laserdiodenanordnung in drei Strahlebenen aufzuteilen und dort sowohl in der X-Achse als auch in der Y-Achse zu kollimieren. Anstelle der Sammellinse 9 ist bei dieser Ausführungsform eine für sämtliche Laserdiodenanordnungen 1 bzw. 1a gemeinsame Sammellinse 13 vorgesehen, mit der die Laserstrahlen dann in dem gemeinsamen Fokuspunkt 14 zusammengeführt bzw. abgebildet werden.

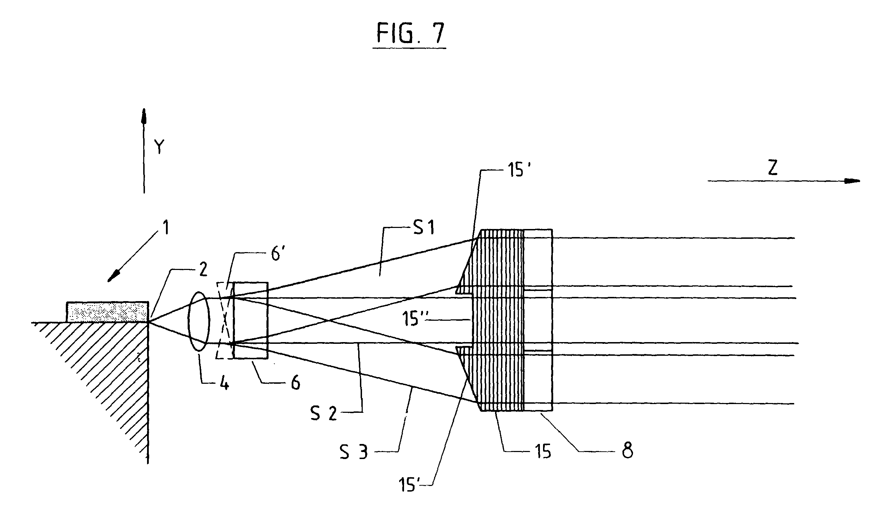

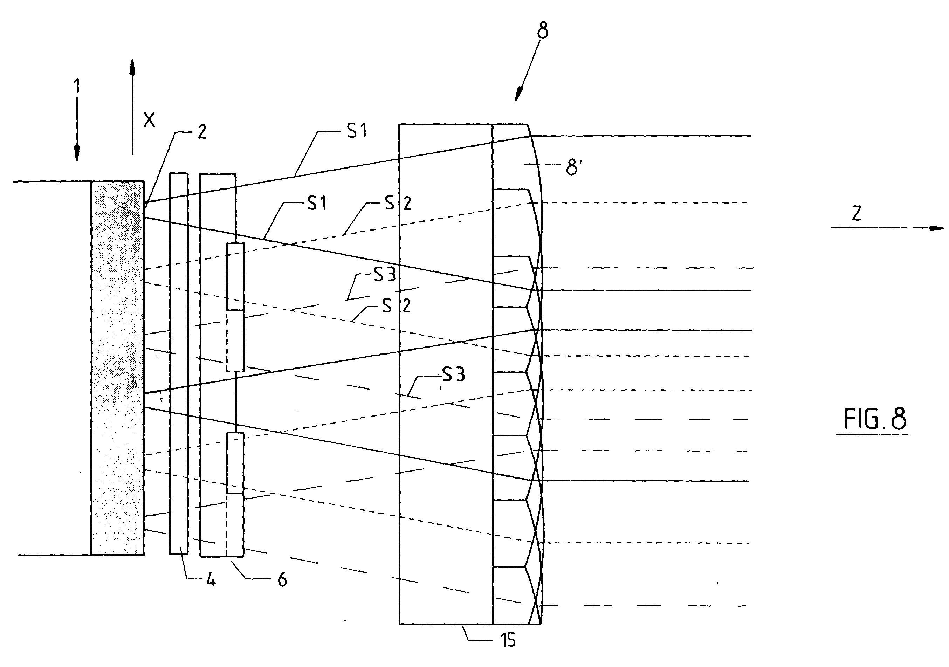

Die Figuren 7 und 8 zeigen eine Ausführungsform, die sich von der Ausführungsfrom der Figuren 1 und 2 im wesentlichen nur dadurch unterscheidet, daß sich die schrägen Flächen der Prismenelemente 6' an der der Zylinderlinsenanordnung 4 zugewandten Seite des Prismenblockes 6 befinden und daß anstelle des Prismenblockes 7 ein Prismenblock 15 vorgesehen ist, welcher in zur Erzielung von drei in Richtung der Y-Achse versetzten Strahlebenen wiederum drei Prismenelemente 15' aufweist, von denen die Prismenflächen der beiden äußeren mit der X-Y-Ebene jeweils einen Winkel einschließen und die Fläche des mittleren Prismenelementes 15' parallel zu dieser Ebene liegt.

Die dem Prismenblock 6 zugewandte Prismenfläche des mittleren Prismenelementes 15' ist vom Boden einer Ausnehmung 15" des Prismenblockes 15 gebildet, wodurch die Länge des Lichtweges durch den Prismenblock 15 in der mittleren verkürzt ist. Hierdurch wird eine Kompensation von Phasen- oder Laufzeitunterschieden der Laserstrahlen S1 - S3 in der Form erreicht, daß eine Fokussierung sämtlicher Strahlen exakt in einer Ebene möglich ist.

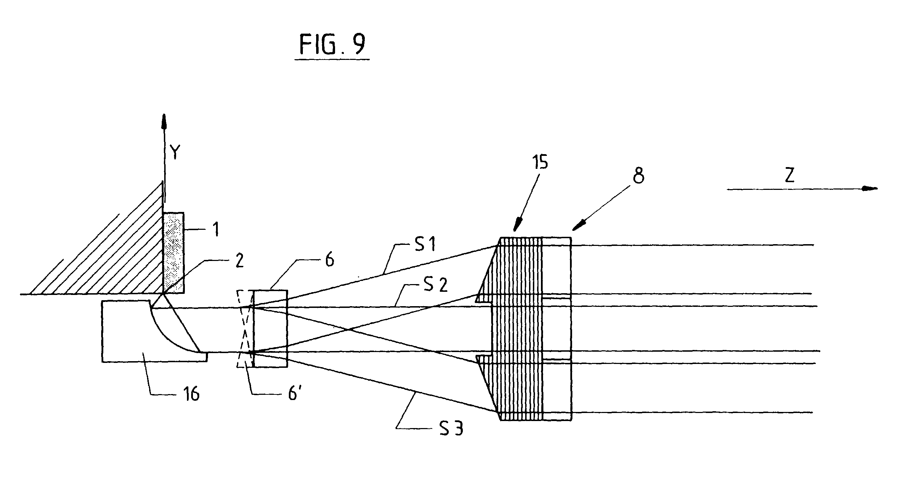

Figur 9 zeigt eine Ausführungsform, die sich von der Ausführungsform der Figuren 7 und 8 im wesentlichen dadurch unterscheidet, daß anstelle der Zylinderlinsenanordnung 4 als erste Kollimationsoptik ein Spiegel 16 verwendet wird, der nur um eine Achse , nämlich um eine Achse parallel zur X-Achse konkav gekrümmt ist und sich in der X-Achse erstreckt. Mit diesem Spiegel wird gleichzeitig eine Umlenkung der Laserstrahlen S1 - S3 um 90° bewirkt, so daß die Emitter oder Emittergruppen 2 der Laserdiodenanordnung 1 bei dieser Ausführung in der X-Y-Ebene angeordnet sind. Der besondere Vorteil besteht hierbei darin, daß bei mehreren Reihen von Emittergruppen in einer gemeinsamen X-Y-Ebene vorgesehen werden können, was u.a. die zum Kühlen verwendeten Mittel wesentlich vereinfacht, da für sämtliche Emittergruppen dann eine gemeinsame Kühleinrichtung möglich ist. Die Reihen der Emittergruppen 2 einer solchen, mehrere Reihen von Emittergruppen aufweisenden Laserdiodenanordnung sind dann in der Y-Achse übereinander vorgesehen, und zwar jeweils mit einem dazwischenliegenden Spiegel 16, der dann auch Teil eines die Emittergruppen 2 tragenden Substrates sein kann.

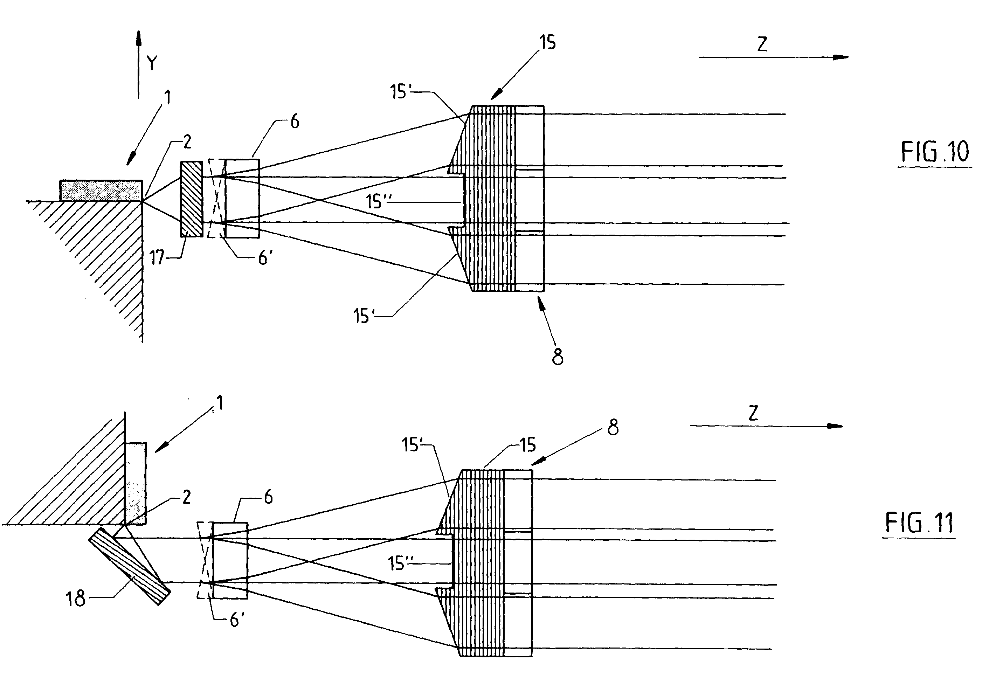

Die in den Figuren 10 und 11 dargestellte Ausführungsform unterscheidet sich von der Ausführungsform der Figuren 7 und 8 im wesentlichen nur dadurch, daß anstelle der Zylinderlinsenanordnung 4 als erste Kollimationsoptik ein holographisch wirkendes, von den Laserstrahlen S1 - S3 durchdrungenes optisches Element 17 (Figur 11) bzw. reflektierendes Element 18 (Figur 11) vorgesehen ist.

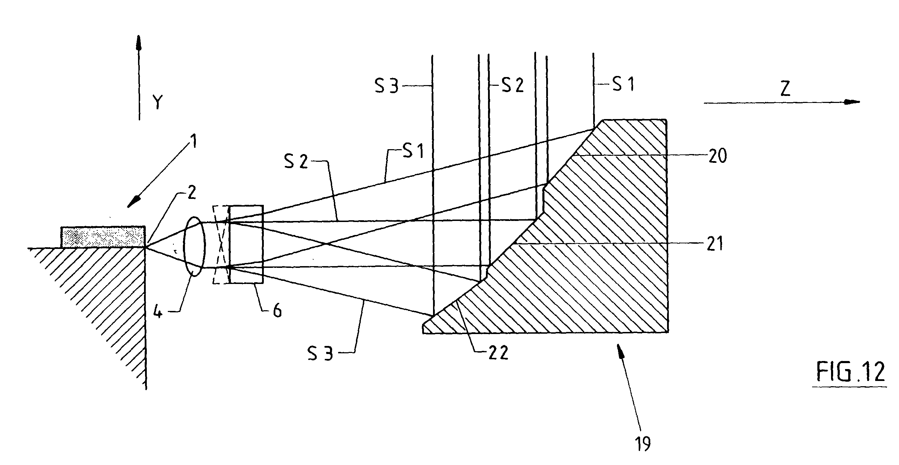

Die Figur 12 zeigt schließlich in Teildarstellung eine weitere mögliche Ausführungsform, die sich von der Ausführungsform der Figur 1 im wesentlichen dadurch unterscheidet, daß anstelle des Prismenblockes 7 eine Reflektions-Einrichtung oder Spiegelanordnung 19 vorgesehen ist, die für jeden durch den Prismenblock 6 in verschiedenem Winkel abgelenkten Laserstrahl S1 - S3 eine Reflektions- oder Spiegelfäche 20 - 22 bildet. Diese liegen jeweils in einer Ebene parallel zu der senkrecht zur Zeichenebene der Figur 12 verlaufenden X-Achse bzw. senkrecht zur Y-Z-Ebene und schließen mit der X-Y-Ebene einen unterschiedlichen Winkel ein, und zwar die Spiegelfläche 21 für den Strahl S2 einen Winkel, der größer als der Winkel der Spiegelfläche 20, und die Spiegelfäche 22 einen Winkel, der größer als der Winkel der Spiegelfläche 21. Die Neigung der Spiegelflächen 20 - 21 ist weiterhin so gewählt, daß die an diesen reflektierten Strahlen parallel zueinander und in unterschiedlichen Strahlebenen liegen, die bei dieser Ausführungsform nicht in Richtung der Y-Achse, sondern in Richtung der Z-Achse gegeneinander versetzt sind. Die reflektierten parallelen Strahlen S1 - S3 werden dann der in dieser Figur nicht dargestellten Zylinderlinsenordnung 8 zugeführt, die dann ebenfalls um 90° gedreht gegenüber der Figur 1 angeordnet ist.

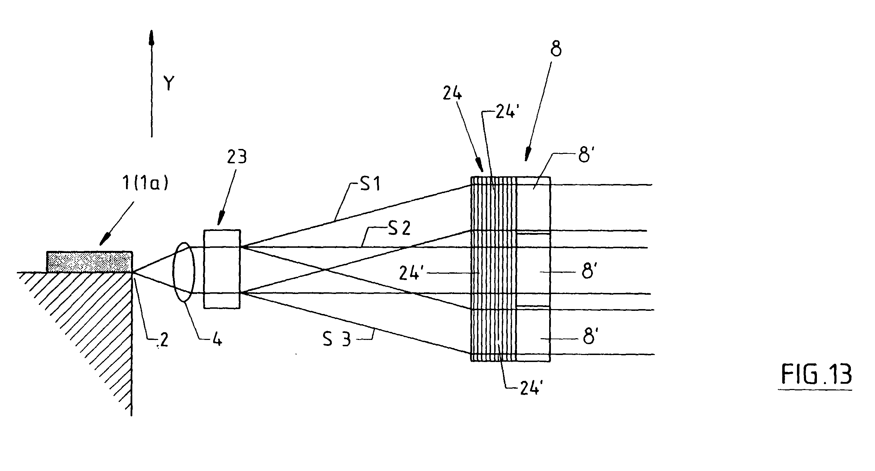

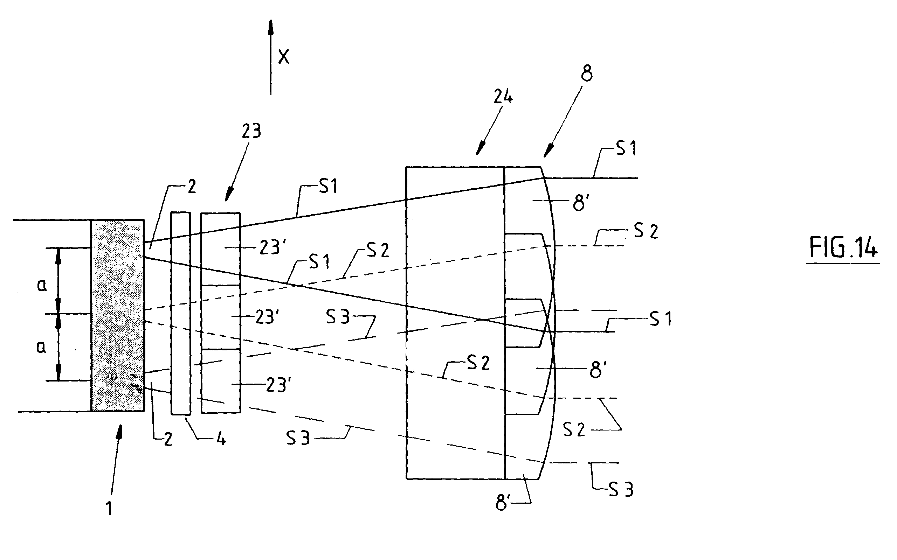

Die Figuren 13 und 14 zeigen in einer Darstellung ähnlich den Figuren 1 und 2 eine weitere mögliche Ausführungsform der Erfindung, die sich von der Ausführungsform der Figuren 1 und 2 im wesentlichen nur dadurch unterscheidet, daß anstelle der die beiden Umlenkeinrichtungen bildenden Prismenblöcke 6 und 7 bzw. anstelle der Prismenelemente 6' und 7' defraktive optische Elemente, d.h. lichtbeugende Elemente, und zwar bei dieser Ausführungsform transmittierende Einrichtungen 23 und 24 vorgesehen sind, die in Richtung der X-Achse versetzt wiederum für drei in dieser Koordinatenrichtung versetzte Emittergruppen 2 bzw. deren Strahlen S1, S2 und S3 drei lichtbeugende Bereiche 23' bzw. 24' derart bilden, daß an der Einrichtung 23 die Strahlen wiederum in unterschiedlichen Winkeln gegenüber der Z-Achse abgelenkt und dann in der Einrichtung 24 in die in der Y-Achse gegeneinander versetzten parallelen Strahlebenen umgelenkt werden.

Die Einrichtungen 23 und 24 bzw. deren Bereiche 23' und 24' sind jeweils zum Beugen von Licht geeignete gitterartige Strukturen.

Zum Umlenken der Laserstrahlen S1 - S3 sind weiterhin auch nichttransmittierende, nämlich reflektierende lichtbeugende Elemente denkbar, und zwar ähnlich dem Reflexionselement 12 bzw. 19, wobei die dortigen Reflexions- oder Spiegelflächen durch entsprechende, eine Reflexion durch Lichtbeugung bewirkende Strukturen ersetzt sind.

In den Figuren 7 - 14 sind Sammellinsen 9 bzw. 14 nicht dargestellt. Auch bei diesen Ausführungen wird aber jeweils eine solche Sammellinse verwendet, wenn die kollimierten Strahlen in einem gemeinsamen Fokuspunkt 3 bzw. 14 abgebildet werden sollen. Selbstverständlich besteht auch bei den Ausführungen der Figuren 7 - 14 grundsätzlich die Möglichkeit, wieder mehrere Reihen von Emitter oder Emittergruppen vorzusehen.

Die Erfindung wurde voranstehend an Ausführungsbeispielen beschrieben. Es versteht sich, daß weitere Abwandlungen und Änderungen möglich sind, ohne daß dadurch der der Erfindung zugrundeliegende Erfindungsgedanke verlassen wird. So ist es möglich, anstelle von mehreren, jeweils eine Gruppe bildenden Emittern auch einzelne Emitter oder mehrere jeweils Untergruppen gebildete Gruppen in der gleichen Weise zu behandeln, wobei jede Untergruppe ihrerseits eine Vielzahl von Emittern aufweist.

### Bezugszeichenliste

- 1, 1a: Laserdiodenanordnung
- 2: Emittergruppe
- 3: Fokuspunkt
- 4: Zylinderlinsenanordnung
- 6, 7, 6a, 7a: Prismenblock
- 6', 7': Prismenelement
- 8, 8a, 8b: Zylinderlinsenanordnung
- 8': Zylinderlinsenelement
- 9: Sammellinse
- 10: Prismenblock
- 11: Scheibe
- 12: Reflektionselement
- 12': Reflektionsfläche
- 13: Sammellinse
- 14: Fokuspunkt
- 15: Prismenblock
- 15': Prismenelement
- 15": Ausnehmung
- 16: Spiegel
- 17, 18: Kollimieroptik
- 19: Spiegel
- 20 - 22: Spiegelfläche
- 23, 24: lichtbeugende Einrichtung
- 23', 24': lichtbeugender Bereich

## Patentansprüche

1. Optische Anordnung für die Kollimation der Laserstrahlen (S1-S3,S1'-S3') mehrerer in einer Reihe oder in mehreren Reihen angeordneter Emitter oder Emittergruppen (2) einer Laserdiodenanordnung (1,1a), bei der die Emitter oder Emittergruppen (2) einer Reihe mit ihrer aktiven Schicht längseiner ersten koordinaten-achsenrichtung in einer gemeinsamen Ebene angeordnet sind und zwar mit einem vorgegebenen Abstand (a) bestehend aus
- einer ersten zylindrisch wirkenden Kollimationsoptik (4, 16, 17, 18), die eine Kollimation der Laserstrahlen (S1-S3,S1'-S3') der Emitter oder Emittergruppen (2) in jeweils einer ersten Ebene (Y-Z-Ebene) bewirkt, die senkrecht zu der ersten Koordinaten achsen richtung (X-Achse) ist, die der Achsrichtung entspricht, in der die Emitter oder Emittergruppen angeordnet sind, und
- einer zweiten zylindrisch wirkenden Kollimationsoptik (8, 8a, 8b), die eine Kollimation der Laserstrahlen (S1-S3,S1'-S3') der Emitter oder Emittergruppen (2) in jeweils einer zweiten Ebene (X-Z-Ebene) bewirkt, die senkrecht zur ersten Ebene (Y-Z-Ebene) und auch senkrecht zu einer zweiten Koordinatenrichtung (Y-Achse) ist,
**dadurch gekennzeichnet,**
- **dass** die optische Anordnung noch Mittel (6,6a,7,7a,7b,12,15,19) umfaßt, die die Laserstrahlen (S1-S3,S1'-S3') benachbarter Emitter oder Emittergruppen (2) in der ersten Ebene (Y-Z-Ebene) derart umlenken, dass die kollimierten Laserstrahlen (S1-S3,S1'-S3') benachbarter Emitter oder Emittergruppen (2) nach dem Durchtritt durch die zweite Kollimationsoptik (8,8a,8b) parallel zueinander in unterschiedlichen, gegeneinander versetzten Strahlebenen vorliegen.

2. Optische Anordnung nach Anspruch 1, **dadurch gekennzeichnet, dass** die Strahlebenen in einer Achsrichtung (Versatzrichtung) senkrecht zur ersten Koordinatenrichtung (X-Achse), vorzugsweise in der zweiten oder in einer dritten Koordinatenrichtung (Y-Achse oder Z-Achse) gegeneinander versetzt vorliegen.

3. Optische Anordnung nach Anspruch 1 oder 2, **dadurch gekennzeichnet, dass** zur Abbildung der Emitter oder Emittergruppen (2) der Laserdiodenanordnung (1, 1a) in einen gemeinsamen Raumbereich oder Fokus-Punkt (3, 14) auf die zweite Kollimationsoptik (8,8a,8b) folgend eine eine Fokussieroptik (9,13) vorgesehen ist, durch die die Laserstrahlen (S1-S3,S1'-S3') in den gemeinsamen Raumbereich oder Fokuspunkt (3,14) abgebildet werden.

4. Optische Anordnung nach einem der Ansprüche 1 bis 3, **dadurch gekennzeichnet, dass** die Umlenkmittel (6, 6a; 7, 7a, 7b) im Strahlverlauf zwischen der ersten Kollimationsoptik (4, 16, 17, 18) und der zweiten Kollimationsoptik (8, 8a, 8b) vorgesehen sind, und zwar derart, dass die Laserstrahlen (S1-S3; S1'-S3') bereits vor dem Eintritt in die zweite Kollimationsoptik oder in dort vorgesehene Kollimationselemente (8') parallel zueinander in den unterschiedlichen Strahlebenen angeordnet sind.

5. Optische Anordnung nach einem der Ansprüche 1 bis 4, **dadurch gekennzeichnet, dass** durch die Mittel zum Umlenken (6, 6a; 7, 7a, 7b; 12, 16, 17, 18) der Laserstrahlen (S1-S3;S1'-S3') wenigstens zwei, vorzugsweise wenigstens drei Strahlebenen gebildet sind.

6. Optische Anordnung nach einem der Ansprüche 1 bis 5, **dadurch gekennzeichnet, dass** die erste und/oder zweite Kollimationsoptik (4, 8, 8a, 8b) von wenigstens einer bikonvexen oder plankonvexen Zylinderlinse mit nicht kreisförmiger Krümmung oder von wenigstens einem konkaven Spiegel (16) oder einer anderen zylinderlinsenartig abbildenden Optik gebildet ist.

7. Optische Anordnung nach einem der Ansprüche 1 bis 6, **dadurch gekennzeichnet, dass** die zweite Kollimationsoptik (8, 8a, 8b) in den Strahlebenen jeweils wenigstens ein Kollimationselement (8') aufweist, und dass diese Kollimationselemente (8') von Strahlebene zu Strahlebene jeweils um einen Betrag (a) in der ersten Koordinatenrichtung (X-Achse) versetzt sind, der dem Abstand (a) der Emitter oder Emittergruppen (2) einer Reihe entspricht oder zu diesem Abstand (a) proportional ist.

8. Optische Anordnung nach Anspruch 7, **dadurch gekennzeichnet, dass** die zweite Kollimationsoptik eine Zylinderlinsenanordnung (8, 8a, 8b) ist, die in den Strahlebenen als Kollimationselement jeweils wenigstens ein Zylinderlinsenelement (8') aufweist, welches mit seiner Zylinderachse in der Versatzrichtung (Y-Achse) oder senkrecht zur zweiten Ebene (X-Z-Ebene) orientiert ist.

9. Optische Anordnung nach Anspruch 8, **dadurch gekennzeichnet, dass** die zweite Zylinderlinseneinrichtung (8, 8a, 8b) bzw. deren Zylinderlinsenelemente (8') plankonvex ausgebildet sind.

10. Optische Anordnung nach Anspruch 8 oder 9, **dadurch gekennzeichnet, dass** die zweite Zylinderlinsenanordnung (8, 8a, 8b) bzw. deren Zylinderelemente (8') eine kreisförmige Krümmung aufweisen.

11. Optische Anordnung nach Anspruch 8 oder 9, **dadurch gekennzeichnet, dass** die zweite Zylinderlinsenanordnung (8, 8a, 8b) bzw. deren Zylinderelemente (8') eine nicht kreisförmige Krümmung aufweisen.

12. Optische Anordnung nach einem der Ansprüche 1 bis 11, **dadurch gekennzeichnet, dass** die Mittel zum Umlenken der Laserstrahlen (S1 - S3; S1' - S3') eine erste Prismenanordnung oder einen ersten Prismenblock (6, 6a) aufweist, der in der ersten Koordinatenrichtung (X-Achse) aufeinander folgend mehrere Prismenelemente (6') aufweist, von denen jedes einem Emitter oder einer Emittergruppe (2) zugeordnet ist und deren Mittelabstand in der ersten Koordinatenrichtung (X-Achse) gleich dem Abstand (a) der Emitter oder Emittergruppen (2) einer Reihe ist, und dass die Prismenelemente (6') durch unterschiedliche Neigung von Prismen-Flächen, d.h. durch unterschiedliche Neigung von Lichteintritts- und/oder -austrittsflächen gegenüber der zweiten Ebene (X-Z-Ebene) oder der Ebene der aktiven Schicht eine unterschiedliche Ablenkung in der jeweiligen ersten Ebene (Y-Z-Ebene) bewirken.

13. Optische Anordnung nach einem der Ansprüche 1 bis 12, **dadurch gekennzeichnet, dass** die Mittel zum Umlenken der Laserstrahlen eine erste lichtreflektierende oder lichtbeugende Anordnung oder ein lichtreflektierendes oder lichtbeugendes Element (12) aufweisen, welches in der ersten Koordinatenrichtung (X-Achse) aufeinanderfolgend mehrere reflektierende oder lichtbeugende Bereiche (12') besitzt, deren Mittelabstand gleich dem Abstand (a) der Emitter oder Emittergruppen (2) ist.

14. Optische Anordnung nach Anspruch 13, **dadurch gekennzeichnet, dass** die lichtreflektierenden Bereiche oder Flächen für eine unterschiedliche Ablenkung der Laserstrahlen (S1-S3; S1'-S3') in der ersten Ebene (Y-Z-Ebene) eine unterschiedliche Neigung gegenüber der zweiten Ebene (X-Z-Ebene) oder der Ebene der aktiven Schicht aufweisen.

15. Optische Anordnung nach einem der Ansprüche 1 bis 14, **dadurch gekennzeichnet, dass** die Mittel zum Umlenken der Laserstrahlen (S1-S3; S1'-S3') einen zweiten Prismenblock oder eine zweite Prismenanordnung (7, 7a, 7b, 15) aufweisen, die im Strahlverlauf bzw. in Richtung einer die optische Achse der Anordnung bildenden Koordinatenrichtung (Y-Achse oder Z-Achse) auf die erste Prismenanordnung (6, 6a) und/oder auf das Umlenkelement (12) folgt und welche für jede Strahlebene wenigstens ein Prismenelement (7', 15') derart bildet, dass die abgelenkten Laserstrahlen (S1-S3; S1'-S3') in solche in den parallelen Strahlebenen umgelenkt werden.

16. Optische Anordnung nach einem der Ansprüche 1 bis 15, **dadurch gekennzeichnet, dass** die Mittel zum Umlenken der Laserstrahlen (S1-S3; S1'-S3') eine zweite reflektierende oder lichtbeugende Anordnung (19) aufweisen, welche im Strahlverlauf bzw. in Richtung einer die optische Achse der Anordnung bildenden Koordinatenrichtung (Z-Achse) auf die erste Prismenanordnung (6, 6a) und/oder auf das erste reflektierende oder lichtbeugende Element (12) folgt und welche für jede Strahlebene wenigstens eine Reflexionsfläche (20, 21, 22) oder einen lichtbeugenden Bereich derart bildet, dass die abgelenkten Laserstrahlen (S1-S3; S1'-S3') in solche in den parallelen Strahlebenen umgelenkt werden.

17. Optische Anordnung nach einem der Ansprüche 1 bis 16, **dadurch gekennzeichnet, dass** für die Kollimation der Laserstrahlen (S1-S3,S1'-S3') einer Laserdiodenanordnung, bei der mehrere Reihen von Emittern oder Emittergruppen (2) vorzugsweise in der zweiten Koordinatenrichtung (Y-Achse) übereinander vorhanden sind, die optische Anordnung mehrfach vorgesehen ist, und zwar für jede Reihe eine optische Anordnung bestehend zumindest aus der ersten Kollimationsoptik (4, 16, 17, 18), aus der zweiten Kollimationsoptik (8, 8a, 8b) sowie aus den Mitteln zum Umlenken der Laserstrahlen benachbarter Emitter oder Emittergruppen (2) in die verschiedenen Strahlebenen.

18. Optische Anordnung nach Anspruch 17, **dadurch gekennzeichnet, dass** die zweiten Kollimationsoptiken (8, 8a, 8b) und/oder die zweiten Prismenanordnungen oder Prismenblöcke (7, 7a, 15) und/oder zweiten lichtreflektierenden oder lichtbeugenden Anordnungen und/oder die Fokussier-Optik (13) für sämtliche Reihen oder für eine Gruppe von Reihen zu einer optischen Baugruppe zusammengefaßt sind.

19. Optische Anordnung nach einem der Ansprüche 3 bis 18, **dadurch gekennzeichnet, dass** die Fokussier-Optik eine solche ist, die wenigstens eine rotationssymmetrisch ausgebildete Sammellinse, beispielsweise wenigstens eine bikonvexe oder plankonvexe Sammellinse (9, 13) aufweist.

## Claims

1. Optical arrangement for the collimation of laser beams (S1-S3; S1'-S3') of several emitters or emitter groups (2), arranged in a row or in several rows, of a laser diode arrangement (1, 1a),
in which the emitters or emitter groups (2) of a row are arranged with their active layer along a first coordinate axis direction, in a common plane, and namely with a predetermined spacing (a), comprising
- a first cylindrically-acting collimation lens (4, 16, 17, 18) which effects a collimation of the laser beams (S1-S3; S1'-S3') of the emitters or emitter groups (2) respectively of a first plane (Y-Z plane) that is perpendicular to the first co-ordinate axis direction (X axis), which corresponds to the axis direction in which the emitters or emitter groups (2) are arranged, and
- a second cylindrically-acting collimation lens (8, 8a, 8b) which effects a collimation of the laser beams (S1-S3; S1'-S3') of the emitters or emitter groups (2) respectively of a second plane (X-Z plane) that is perpendicular to the first plane (Y-Z plane) and also perpendicular to a second coordinate direction (Y axis), **characterised in that**
- the optical arrangement also comprises means (6, 6a, 7, 7a, 7b, 12, 15, 19) which deflect the laser beams (S1-S3; S1'-S3') of adjacent emitters or emitter groups (2) in the first plane (Y-Z plane) in such a way that the collimated laser beams (S1-S3; S1'-S3') of adjacent emitters or emitter groups (2), after passing through the second collimation lens (8, 8a, 8b), are parallel to one another in different beam planes offset against one another.

2. Optical arrangement in accordance with claim 1, **characterised in that** the beam planes are in an axial direction (offset direction) perpendicular to the first coordinate direction (X axis), preferably in the second or in a third coordinate direction (Y axis or Z axis), offset against one another.

3. Optical arrangement in accordance with claim 1 or 2, **characterised in that** for the representation of the emitter or emitter groups (2) of the laser diode arrangement (1, 1a) in a common spatial area or focus point (3, 14), following on from the second collimation lens (8, 8a, 8b), there is provided a focusing lens (9, 13) through which the laser beams (S1-S3; S1'-S3') are represented in the common spatial area or focus point (3, 14).

4. Optical arrangement in accordance with one of the claims 1 to 3, **characterised in that** the deflection means (6, 6a; 7, 7a, 7b) are provided in the beam path between the first collimation lens (4, 16, 17, 18) and the second collimation lens (8, 8a, 8b), and in fact such that the laser beams (S1-S3; S1'-S3') are already arranged parallel to one another in the different beam planes before entry into the second collimation lens or into collimation elements (8') provided there.

5. Optical arrangement in accordance with one of the claims 1 to 4, **characterised in that** through the deflection means (6, 6a; 7, 7a, 7b; 12, 16, 17, 18) of the laser beams (S1-S3; S1'-S3'), at least two, preferably at least three beam planes are formed.

6. Optical arrangement in accordance with one of the claims 1 to 5, **characterised in that** the first and/or second collimation lens (4, 8, 8a, 8b) is formed of at least a bi-convex or plano-convex cylinder lens with non-circular curvature, or of at least one concave mirror (16) or another lens that represents in the manner of a cylinder lens.

7. Optical arrangement in accordance with one of the claims 1 to 6, **characterised in that** the second collimation lens (8, 8a, 8b) in the beam planes respectively has at least one collimation element (8'), and that these collimation elements (8') are respectively offset, from beam plane to beam plane, by an amount (a) in the first co-ordinate direction (X axis), which corresponds to the spacing (a) of the emitters or emitter groups (2) of a row, or is proportional to this spacing (a).

8. Optical arrangement in accordance with claim 7, **characterised in that** the second collimation lens is a cylinder lens arrangement (8, 8a, 8b), which in the beam planes respectively has, as a collimation element, at least one cylinder lens element (8'), which is oriented with its cylinder axis in the offset direction (Y axis) or perpendicular to the second plane (X-Z plane).

9. Optical arrangement in accordance with claim 8, **characterised in that** the second cylinder lens device (8, 8a, 8b) or its cylinder lens elements (8') are designed to be plano-convex.

10. Optical arrangement in accordance with claim 8 or 9, **characterised in that** the second cylinder lens arrangement (8, 8a, 8b) or its cylinder elements (8') have a circular curvature.

11. Optical arrangement in accordance with claim 8 or 9, **characterised in that** the second cylinder lens arrangement (8, 8a, 8b) or its cylinder elements (8') have a non-circular curvature.

12. Optical arrangement in accordance with one of the claims 1 to 11, **characterised in that** the means for deflecting the laser beams (S1-S3; S1'-S3') has a first prism arrangement or a first prism block (6, 6a) which has several prism elements (6') following on from one another in the first coordinate direction (X axis), each of which is assigned to an emitter or emitter group (2), and whose centre distance in the first coordinate direction (X axis) is equal to the spacing (a) of the emitters or emitter groups (2), and that the prism elements (6'), through different incline of prism surfaces, i.e. through different inclination of light entry surfaces and/or light exit surfaces relative to the second plane (X-Z plane) or the plane of the active layer, effect different deflection in the respective first plane (Y-Z plane).

13. Optical arrangement in accordance with one of the claims 1 to 12, **characterised in that** the means for deflecting the laser beams have a first light-reflecting or light-bending arrangement or a light-reflecting or light-bending element (12) which, in the first co-ordinate direction (X axis) has several reflective or light-bending areas (12') following on from one another, whose centre distance is equal to the spacing (a) of the emitters or emitter groups (2).

14. Optical arrangement in accordance with claim 13, **characterised in that** for a different deflection of the laser beams (S1-S3; S1'-S3') in the first plane (Y-Z plane) the light-reflecting areas or surfaces have a different inclination relative to the second plane (X-Z plane) or the plane of the active layer.

15. Optical arrangement in accordance with one of the claims 1 to 14, **characterised in that** the means for deflecting the laser beams (S1-S3; S1'-S3') have a second prism block or a second prism arrangement (7, 7a, 7b, 15) which, in the beam path or in the direction of a coordinate direction (Y axis or Z axis) forming the optical axis of the arrangement, follows on from the first prism arrangement (6, 6a) and/or from the deflection element (12), and which for each beam plane forms at least one prism element (7', 15') in such a way that the deflected laser beams (S1-S3; S1'-S3') are deflected into such in the parallel beam planes.

16. Optical arrangement in accordance with one of the claims 1 to 15, **characterised in that** the means for deflecting the laser beams (S1-S3; S1'-S3') have a second reflective or light-bending arrangement (19) which, in the beam path or in the direction of a coordinate direction (Z axis) forming the optical axis of the arrangement, follows on from the first prism arrangement (6, 6a) and/or from the first reflective or light-bending element (12), and which for each beam plane forms at least one reflection surface (20, 21, 22) or a light-bending area in such a way that the deflected laser beams (S1-S3; S1'-S3') are deflected into such in the parallel beam planes.

17. Optical arrangement in accordance with one of the claims 1 to 16, **characterised in that** for the collimation of the laser beams (S1-S3; S1'-S3') of a laser diode arrangement, in which there are several rows of emitters or emitter groups (2), preferably in the second coordinate direction, above one another, the optical arrangement is provided several times over, and in fact for each row an optical arrangement comprising at least the first collimation lens (4, 16, 17, 18), the second collimation lens (8, 8a, 8b), as well as the means for deflecting the laser beams of adjacent emitters or emitter groups (2) into the different beam planes.

18. Optical arrangement in accordance with claim 17 **characterised in that** second collimation lenses (8, 8a, 8b) and/or the second prism arrangements or prism blocks (7, 7a, 15) and/or second light-reflecting or light-bending arrangements and/or the focusing lens (13) are combined to form one optical subassembly for all rows or for a groups of rows.

19. Optical arrangement in accordance with one of the claims 3 to 18, **characterised in that** the focusing lens is such that it has at least one convergent lens, designed to be rotationally symmetrical, for example at least one bi-convex or plano-convex convergent lens (9, 13).

## Revendications

1. Montage optique pour la collimation des rayons laser (S1-S3, S1'-S3') de plusieurs émetteurs ou groupes d'émetteurs (2) d'un montage de diodes laser (1, 1a) disposés sur une seule ou plusieurs rangées, dans lequel les couches actives des émetteurs ou groupes d'émetteurs (2) sont disposées parallèlement à une première direction des axes des coordonnées, dans un plan commun, et à une distance (a) prédéfinie les unes des autres, ledit système étant constitué de :
- une première optique de collimation (4, 16, 17, 18) à effet cylindrique provoquant une collimation des rayons laser (S1-S3, S1'-S3') des émetteurs ou groupes d'émetteurs (2) dans un premier plan (plan Y-Z) perpendiculaire à la première direction des axes des coordonnées (axe X) correspondant à la direction de l'axe dans lequel les émetteurs ou groupes d'émetteurs sont disposés, et
- une deuxième optique de collimation (8, 8a, 8b) à effet cylindrique provoquant une collimation des rayons laser (S1-S3, S1'-S3') des émetteurs ou groupes d'émetteurs (2) dans un second plan (plan X-Z) perpendiculaire au premier plan (plan Y-Z) ainsi qu'à une deuxième direction des coordonnées (axe Y) et
**caractérisé en ce que**
- le montage optique comprend encore des moyens (6, 6a, 7, 7a, 7B, 12, 15, 19) déviant les rayons laser (S1-S3, S1'-S3') d'émetteurs ou groupes d'émetteurs (2) voisins dans le premier plan (plan Y-Z), de telle sorte que les rayons laser collimatés (S1-S3, S1'-S3') d'émetteurs ou groupes d'émetteurs (2) voisins soient, après avoir traversé la deuxième optique de collimation (8, 8a, 8b), disposés parallèlement les uns aux autres, dans des plans des rayons différents, et décalés les uns par rapport aux autres.

2. Montage optique selon la revendication 1, **caractérisé en ce que** les plans des rayons sont décalés les uns par rapport aux autres dans une direction de l'axe (direction de déplacement), perpendiculairement à la première direction des coordonnées (axe X), et de préférence dans la deuxième ou troisième direction des coordonnées (axe Y ou Z).

3. Montage optique selon la revendication 1 ou 2, **caractérisé en ce que** une optique de focalisation (9, 13) via laquelle les rayons laser (S1-S3, S1'-S3') sont appliqués dans l'espace commun ou au point de focalisation (3, 14) commun a été prévue après la deuxième optique de collimation (8, 8a, 8b), afin d'appliquer les émetteurs ou groupes d'émetteurs (2) du montage de diodes laser (1, 1a) dans un espace commun ou à un point de focalisation (3, 14) commun.

4. Montage optique selon une des revendications 1 à 3, **caractérisé en ce que** les moyens de déviation (6, 6a ; 7, 7a, 7b) ont été prévus dans le trajet des rayons entre la première optique de collimation (4, 16, 17, 18) et la deuxième optique de collimation (8, 8a, 8b), de telle sorte que les rayons laser (S1-S3 ; S1'-S3') aient déjà été disposés parallèlement les uns aux autres dans les différents plans des rayons, avant même de pénétrer dans la deuxième optique de collimation ou dans des éléments de collimation (8') prévus à cet endroit.

5. Montage optique selon une des revendications 1 à 4, **caractérisé en ce que** au moins deux, et de préférence au moins trois plans des rayons ont été constitués par les moyens de déviation (6, 6a ; 7, 7a, 7b ; 12, 16, 17, 18) des rayons laser (S1-S3 ;S1'-S3').

6. Montage optique selon une des revendications 1 à 5, **caractérisé en ce que** la première et/ou la deuxième optique de collimation (4, 8, 8a, 8b) est constituée d'au moins une lentille cylindrique biconvexe ou plane-convexe à courbure non circulaire ou d'au moins un miroir (16) concave ou une autre optique d'application sous la forme d'une lentille cylindrique.

7. Montage optique selon une des revendications 1 à 6, **caractérisé en ce que**, dans les différents plans de rayonnement, la deuxième optique de collimation (8, 8a, 8b) comprend au moins un élément de collimation (8'), et **en ce que** ces éléments de collimation (8') ont été déplacés d'un plan des rayons vers un autre, sur une valeur (a) et dans la première direction des coordonnées (axe X), la valeur (a) correspondant à la distance (a) entre les émetteurs ou groupes d'émetteurs (2) d'une rangée ou étant proportionnelle à cette distance (a).

8. Montage optique selon la revendication 7, **caractérisé en ce que** la deuxième optique de collimation est un montage de lentilles cylindriques (8, 8a, 8b) présentant, dans les plans des rayons, en tant qu'élément de collimation, au moins un élément de lentilles cylindriques (8') dont l'axe cylindrique est orienté dans la direction de déplacement (axe Y) ou perpendiculairement au deuxième plan (plan X-Z).

9. Système optique selon la revendication 8, **caractérisé en ce que** le deuxième montage de lentilles cylindriques (8, 8a, 8b) ou ses éléments de lentilles cylindriques (8') sont plans-convexes.

10. Système optique selon la revendication 8 ou 9, **caractérisé en ce que** le deuxième montage de lentilles cylindriques (8, 8a, 8b) ou ses éléments cylindriques (8') présentent une courbure circulaire.

11. Système optique selon la revendication 8 ou 9, **caractérisé en ce que** le deuxième montage de lentilles cylindriques (8, 8a, 8b) ou ses éléments cylindriques (8') présentent une courbure non-circulaire.

12. Système optique selon une des revendications 1 à 11, **caractérisé en ce que** les moyens de déviation des rayons laser (S1 - S3 ; S1' - S3') présentent un premier montage de prismes ou un premier bloc de prismes (6, 6a) comprenant, dans la première direction des coordonnées (axe X), plusieurs éléments de prismes (6'), chaque élément étant relié à un émetteur ou groupe d'émetteurs (2) et la distance moyenne entre les éléments dans la première direction des coordonnées (axe X) correspondant à la distance (a) entre les émetteurs ou groupes d'émetteurs (2) d'une rangée, et **en ce que** les éléments de prismes (6') provoquent une déviation différente dans le premier plan (plan Y-Z), par inclinaison différente des surfaces de prismes, autrement dit par inclinaison différente de surfaces d'entrée et/ou de sortie de la lumière par rapport au deuxième plan (plan X-Z) ou au plan de la couche active.

13. Montage optique selon une des revendications 1 à 12, **caractérisé en ce que** les moyens de déviation des rayons laser présentent un premier montage réfléchissant ou inclinant la lumière ou un élément (12) réfléchissant ou inclinant la lumière, ledit élément présentant, dans la première direction des coordonnées (axe X), plusieurs zones (12') successives réfléchissant ou inclinant la lumière, et dont l'écartement moyen correspond à la distance (a) entre les émetteurs ou groupes d'émetteurs (2).

14. Montage optique selon la revendication 13, **caractérisé en ce que** les zones ou surfaces réfléchissant la lumière présentent, pour une déviation différente des rayons laser (S1-S3 ; S1'-S3') dans le premier plan (plan Y-Z), une inclinaison différente par rapport au deuxième plan (plan X-Z) ou au plan de la couche active.

15. Montage optique selon une des revendications 1 à 14, **caractérisé en ce que** les moyens de déviation des rayons laser (S1-S3 ; S1'-S3') présentent un second bloc ou montage de prismes (7, 7a, 7b, 15) suivant, dans le trajet des rayons ou dans la direction d'une des directions des coordonnées (axe Y ou Z) formant l'axe optique du montage, le premier montage de prismes (6, 6a) et/ou l'élément de déviation (12) et formant, pour chaque plan des rayons, au moins un élément de prismes (7', 15'), de telle sorte que les rayons laser déviés (S1-S3 ;S1'-S3') en tant que tels soient déviés dans les plans des rayons parallèles.

16. Montage optique selon une des revendications 1 à 15, **caractérisé en ce que** les moyens de déviation des rayons laser (S1-S3 ; S1'-S3') présentent un deuxième montage (19) réfléchissant ou inclinant la lumière, lequel suit, dans le trajet des rayons ou dans la direction d'une des directions des coordonnées (axe Z) formant l'axe optique du montage, le premier élément (12) réfléchissant ou inclinant la lumière, et forme, pour chaque plan des rayons, au moins une surface de réflexion (20, 21, 22) ou une zone inclinant la lumière, de telle sorte que les rayons laser défléchis (S1-S3 ; S1'-S3') en tant que tels soient déviés dans les plans des rayons parallèles.

17. Montage optique selon une des revendications 1 à 16, **caractérisé en ce que**, pour la collimation des rayons laser (S1-S3, S1'-S3') d'un montage de diodes laser dans lequel plusieurs rangées d'émetteurs ou de groupes d'émetteurs (2) ont été disposés les uns au dessus des autres, de préférence dans la deuxième direction des coordonnées (axe Y), le montage optique a été prévu plusieurs fois, chaque rangée présentant un montage optique composé au moins de la première optique de collimation (4, 16, 17, 18), de la deuxième optique de collimation (8, 8a, 8b) et de moyens de déviation des émetteurs ou groupes d'émetteurs (2) voisins des rayons laser dans les différents plans des rayons.

18. Montage optique selon la revendication 17, **caractérisé en ce que** les deuxièmes optiques de collimation (8, 8a, 8b) et/ou les deuxièmes montages ou blocs de prismes (7, 7a, 15) et/ou les deuxièmes montages réfléchissant ou inclinant la lumière et/ou l'optique de focalisation (13) ont été rassemblés pour toutes les rangées ou pour un groupe de rangées en un module optique.

19. Montage optique selon une des revendications 3 à 18, **caractérisé en ce que** l'optique de focalisation présente au moins une lentille de convergence à symétrie de révolution comme par exemple au moins une lentille de convergence (9, 13) biconvexe ou plane-convexe.
